# EUROPÄISCHE PATENTSCHRIFT

(11) **EP 0 429 486 B1**
(45) Veröffentlichungstag und Bekanntmachung des Hinweises auf die Patenterteilung: **20.04.1994**
(21) Anmeldenummer: 89908810.8
(22) Anmeldetag: 01.08.1989
(51) Int. Cl.: H03K 19/0185, H03K 19/173

(54) **CHIPRESIDENTE ZWISCHENTREIBER FÜR DISKRETE WSI-SYSTEME**
IN-CHIP INTERMEDIATE DRIVER FOR DISCRETE WSI SYSTEMS
CIRCUITS D'ATTAQUE INTERMEDIAIRES INTEGRES DANS LES PUCES POUR SYSTEMES WSI DISCRETS

(30) Priorität: 16.08.1988 DE 3827802
(43) Veröffentlichungstag der Anmeldung: 05.06.1991
(73) Patentinhaber: SIEMENS AKTIENGESELLSCHAFT, 80333 München (DE)
(72) Erfinder: RAMACHER, Ulrich, D-8000 München 2 (DE)
(86) Internationale Anmeldenummer: DE8900507
(87) Internationale Veröffentlichungsnummer: WO9002449

(56) Entgegenhaltungen:
- EP-A- 0 023 118
- US-A- 4 239 981
- Datasheet: "UM6502/UM6507/UM6512 8-bit Microprocessors" April 1985 herausgegeben: UMC, United Micro-electronics Corp (Taipei Taiwan, Republic of China) pages 1-12

## Beschreibung

Das Konzept der hybriden Wafer-Scale-Integrationssysteme, kurz auch WSI genannt, stammt bereits aus den 60iger Jahren. Dem Konzept liegt die Idee zugrunde, einzelne Chips auf einem Wafer zu integrieren, der als solcher selbst steckbar ist. Da die einzelnen Chips hierbei hochintegrierte Schaltungen beinhalten, ist es somit möglich, spezielle leistungsfähige Bausteine für die verschiedenen Anwendungsmöglichkeiten herzustellen.

Mit Hilfe neuerer Design-, Herstellungs- und Testtechniken und mit dem immer größer werdenden Bedarf an hochintegrierten Schaltungen und Bausteinen steigt die Bedeutung der WSI-Schaltungen für die verschiedenen Anwendungsbereiche. So existieren bereits für kommerzielle Zwecke 4-Megabit-WSI-Speicher, die in Japan von NTT Musashino Electrical Comm. Lab. in Tokio hergestellt wurden und zur Speicherung des gesamten Kanji-Alphabets dienen. Neben einer solchen Speichermöglichkeit bieten die WSI-Schaltungen auch die Möglichkeit zum Aufbau sehr komplexer anwendungsspezifischer Bausteine. Die Vorteile der Waferscale-Integrationssysteme liegt zum einen darin, daß eine gewünschte Schaltung höher integrierbar ist, daß die Verbindungen der Chips untereinander über kürzere Zuleitungen erfolgt und daß weiterhin eine geringere Anzahl von Anschlüssen aus dem Wafer herausgeführt werden müssen. Diese Vorteile erhöhen die Zuverlässigkeit der gewünschten Schaltung.

Bei der diskreten Wafer-Scale-Integration werden vorgetestete Chips auf einem vorverdrahteten Wafer montiert und gebondet. Als Wafersubstrat dient meistens Silizium, weil die Waferverdrahtung kostengünstig mit einem Standard-Mehrlagenprozeß erzeugt werden kann. Die Leitungseigenschaften einer solchen Waferverdrahtung jedoch verbieten den Gebrauch langer Zuleitungen bei hohen Zeittakten, so daß Zwischentreiber eingesetzt werden müssen. Ein weiterer Gesichtspunkt beim Auslegen von WSI-Systemen ist die Wärmeableitung des gesamten Wafer-Scale-Integrationssystems, in dem bis zu 1000 Watt in Hitze umgesetzt werden kann.

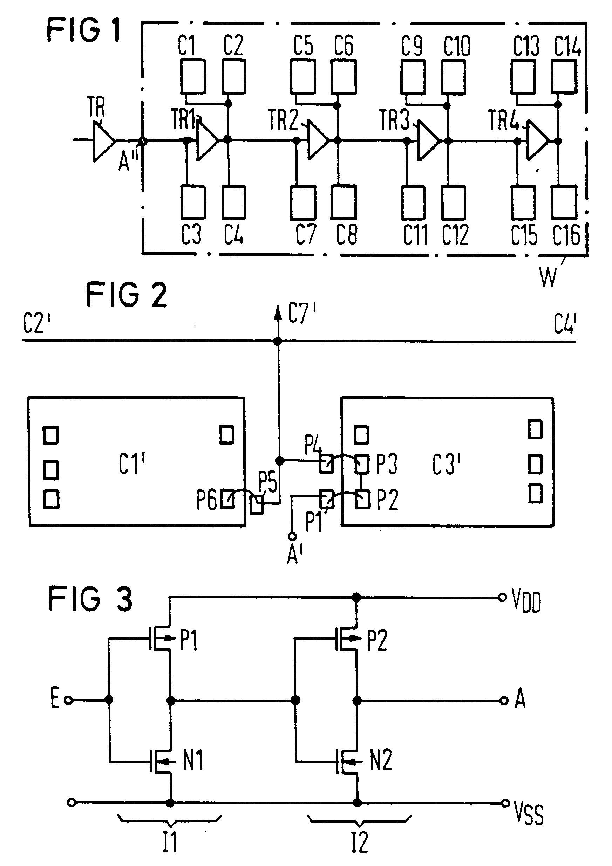

Eine Lösung des Standes der Technik zu dem Problem der langen Zuleitungen bei hohen Zeittakten für WSI-Systeme zeigt Figur 1. Hier sind separate Treiberchips dargestellt, die zwischen den einzelnen Chips geschaltet werden. Zusätzlich müssen die separaten Treiberchips zu den eigentlichen Funktionschips plaziert, gebondet und getestet werden. Dies ist auch aus der Literatur in der Veröffentlichung IEEE Spectrum, Okt. 1984 "The Trails of Wafer-Scale Integration" von Jack F. MacDonald et al auf Seite 35, rechte Spalte bis Seite 36, linke Spalte bekannt, wobei die genannte Veröffentlichung auch einen Überblick über die Entwicklung und den Stand der Technik bezüglich der Waferscale-Integrationssysteme bietet.

Die Nachteile zusätzlicher Treiberchips bestehen in einem erhöhten Verdrahtungsaufwand, einem erhöhten Flächenbedarf der gesamten Schaltung sowie in zusätzlichen Test für die separaten Treiberchips.

Der Erfindung liegt die Aufgabe zugrunde, diskrete Wafer-Scale-Integrationssysteme anzugeben, die einen einfacheren Aufbau und eine erhöhte Zuverlässigkeit als heutige Systeme des Standes der Technik bieten. Insbesondere soll mit der Erfindung das Problem langer Zuleitungen bei hohen Taktraten für die WSI-Systeme gelöst werden.

Diese Aufgabe wird erfindungsgemäß durch die Ausbildung eines Waferscale-Integrationssystems nach dem kennzeichnenden Teil des ersten Patentanspruchs gelöst.

Weitere Ausgestaltungen der Erfindung, insbesondere der Aufbau eines Zwischentreibers, sind in den abhängigen Ansprüchen 2 bis 5 angegeben und werden dort näher erläutert.

Neben dem Vorteil der verminderten elektrischen Leistungsaufnahme im Vergleich zu einem äquivalenten Platinenaufbau, ist die Realisierung der erfindungsgemäßen chipresidenten Zwischentreiber für die wafer-Scale-Integrationssysteme innerhalb jedes Verdrahtungssubstrats mit Hilfe jeder Chiptechnologie möglich. Für die Chips ist zur Zusätzlichen Implementierung der Zwischentreiber lediglich ein 400 µm breiter Streifen an einer Chipseite vorzusehen, der bei den meisten Chips ohnehin verfügbar ist. Sollten einzelne der Chips auch als diskrete Bausteine Verwendung finden, so ist es nicht erforderlich, die Ein- bzw. Ausgänge des Zwischentreibers mit den äußeren Anschlüssen des Bausteins zu verbinden. Somit können dieses Chips sowohl für diskrete Waferscale-Integrationssysteme wie auch für die Anwendung von einzelnen integrierten Schaltungen benutzt werden.

Ein Ausführungsbeispiel der Erfindung ist in den Zeichnungen Figur 2 und Figur 3 dargestellt und wird im folgenden näher beschrieben. Es zeigen:
- Figur 1: den Einsatz von Zwischentreibern in Wafer-Scale-Integrationssystemen nach dem Stand der Technik,
- Figur 2: die erfindungsgemäße chipresidente Realisierung der Zwischentreiber auf einzelnen Chips,
- Figur 3: eine beispielhafte Realisierung eines Zwischentreibers in CMOS-Technologie.

Figur 1 zeigt ein WSI-System nach dem Stand der Technik, wobei auf einem Wafer W 16 einzelne Chips C1, C2,...C15, C16 aufgeklebt und zum Teil über separate Treiberchips TR1, TR2,TR3 und TR4 miteinander verbunden sind. Die Anschlüsse an den einzelnen Chips werden hierbei gebondet und die so angeschlossenen Zuleitungen mit den Chips untereinander sowie mit den separaten Treiberchips verbunden.

Im einzelner sind in dem beispielhaften WSI-System nach Figur 1 die Chips C1, C2, C4 und C7 sowie der Eingang des zweiten separaten Treiberchips TR2 mit dem Ausgang des ersten Treiberchips TR1 verbunden, der Ausgang des zweiten Treiberchip TR2 wiederum ist mit dem Chip C5, C6, C8 und C11 verschaltet. Gleichzeitig ist der Ausgang des zweiten Treiberchips TR2 mit dem Eingang des dritten Treiberchips TR3 verbunden und der Ausgang des dritten Treiberchips TR3 ist mit den Chips C9, C10, C12 und C 15 verschaltet. Der Ausgang des dritten Treiberchips TR3 ist weiterhin mit dem Eingang des vierten Treiberchips TR4 verbunden wobei dessen Ausgang mit den Chips C13, C14 und C16 verschaltet ist. Der Eingang des ersten Treiberchips TR1 zusammen mit dem Chip C3 wird mit Hilfe eines äußeren Signaltreibers TR angesteuert und ist mit diesem über äußere Anschlüsse A'' des WSI-Systems verbunden. Die separaten Treiberchips TR1, TR2, TR3 und TR4 haben hierbei die Aufgabe, die Verluste bei zu langen Zuleitungswegen beispielsweise von dem Anschluß A'' zu den Chips C13, C14 oder C16 zu kompensieren und eine sichere Funktionsweise der Schaltung sicherzustellen. Diese zusätzlichen Treiberchips müssen jedoch wie eingangs bereits erwähnt zusätzlich auf dem Wafer W aufgebracht werden, gebondet und mit Zuleitungen versehen werden und anschließend müssen diese Treiberchips auch ausgetestet werden.

Figur 2 zeigt eine erfindungsmäße chipresidente Realisierung der Zwischentreiber auf den einzelnen Chips,wobei externe Treiberchips, wie sie in der Realisierung nach Figur 1 benötigt werden, hierdurch entfallen. Dargestellt in Figur 2 sind lediglich zwei auf einem nicht eingezeichneten Wafer aufgebrachte Chips C1' und C3'. Das in Figur 1 realisierte separate Treiberchip TR1 ist hierbei innerhalb des Chips C3' implementiert. Im einzelnen zeigt Figur 2 daß von dem Anschluß A' des WSI-Systems die Zuleitung zu einem ersten Wafer-Pad P1 gelegt ist, wobei von dort eine elektrische Zuleitung auf das Pad P2 des Chips C3' erfolgt. Hierbei kann die elektrische Verbindung zu dem Wafer-Pad P1 und einem zusätzlichen Pad P2 auf dem Chip C3' beispielsweise gebondet werden, wobei eine weiterführende Leitung zu einem zweiten Pad P3 auf dem Chip C3' führt. Im Bereich des zweiten Pads P3 ist auch der erforderliche Zwischentreiber untergebracht der den separaten Treiberchip TR1 nach Figur 1 ersetzen soll. Das Pad P2 des Chips C3' kann zusätzlich zur Eingangsbelegung des C3'-Chips herangezogen werden .Der Ausgang des implementierten Zwischentreibers wird über das Pad P3 mit dem Waferpad P4 verbunden. Diese elektrische Verbindung kann ebenfalls wieder gebondet werden. In der weiteren Verdrahtung entspricht die Figur 2 der in Figur 1, so daß das Wafer-Pad P4 mit einem Wafer-Pad P5 verbunden ist, welcher über eine elektrische Zuleitung mit dem Pad P6 des Chips C1' verschaltet ist. Zusätzlich ist das Pad P4 über Zuleitungen mit den Chips C2', C4' und C7' verbunden, die hier aus Gründen der Übersichtlichkeit nicht eingezeichnet wurden. Zusätzlich zu den genannten Pads auf den Chips C1' und C3' sind weitere Pads auf den Chips dargestellt, die als Ein- und Ausgänge für die Chips C1' und C3' dienen.

Figur 3 zeigt eine beispielhafte Realisierung eines Zwischentreibers in CMOS-Technologie falls der Chip mit Hilfe einer solchen Technologie aufgebaut ist. Dargestellt sind zwei hintereinandergeschaltete Inverterstufen I1, I2, die jeweils einen p-und einen n-Kanal MOS-Feloeffekttransistor enthalten.Ein erster Anschluß des ersten n-Kanal MOS-Feldeffekttransistors N1 der ersten Inverterstufe I1 und ein erster Anschluß des ersten n-Kanal MOS-Feldeffekttranistors N2 der zweiten Inverterstufe I2 ist hierbei mit der Masse V_{SS} und ein erster Anschluß des p-Kanal-MOS-Feldeffekttransistors P1 der ersten Inverterstufe I1 sowie ein erster Anschluß des p-Kanal-MOS-Feldeffekttransistors P2 der zweiten Inverterstufe I2 ist mit der Versorgungsspannung V_{DD} verbunden. Die beiden Gateanschlüsse des p-und n-Kanal Feldeffekttransistors P1 und N1 bilden gemeinsam den Eingang E des Zwischentreibers, während der zweite Anschluß des p- und n-Kanal-MOS-Feldeffekttransistors P1 und N1 der ersten Inverterstufe I1 mit dem Gateanschluß des p-Kanal-MOS-Feldeffekttransistors P2 und dem Gateanschluß des n-Kanal-MOS-Feldeffekttransistors N2 der zweiten Invertersufe I2 verschaltet ist. Der Ausgang A des Zwischentreibers wird durch den zweiten Anschluß des p-kanal-MOS-Feldeffekttransistors P2 gemeinsam mit dem zweiten Anschluß des n-Kanal-MOS-Feldeffekttransistors N2 der zweiten Inverterstufe I2 gebildet.

Hierbei zeigen die Figur 2 und Figur 3 lediglich eine beispielhafte Ausbildung, wobei in Figur 2 auch eine Realisierung denkbar ist, in der ein implementierter Zwischentreiber lediglich zusätzlich auf einem Chip untergebracht ist und mit diesem selbst nicht in elektrischer Verbindung steht. Die Zwischentreiber benötigen hierbei lediglich einen etwa 400 µm breiten Streifen auf einer Chipseite, der beispielsweise bei kundenspezifischen Chips jederzeit verfügbar ist. Ein so realisiertes WSI-System ist in jeder Chiptechnologie und in jedem Verdrahtungssubstrat denkbar. Der in Figur 3 realisierte Zwischentreiber setzt jedoch ein Chip in CMOS-Technologie voraus.

## Patentansprüche

1. Zwischentreiber für diskrete Wafer-Scale-Integrationssysteme, in welchen eine Vielzahl von Chips (C1', C3', C4', C7') auf einem vorverdrahteten Wafer montiert sind, die Vielzahl von Chips mindestens teilweise untereinander und mindestens teilweise mit Ein- und Ausgängen (A') über gebondete Chipzuleitungen verbunden sind,
**dadurch gekennzeichnet,**
- daß mindestens auf einem Chip der Vielzahl von Chips ein hochintegrierter Schaltkreis zusammen mit dem Zwischentreiber monolithisch integriert ist
- und daß der Zwischentreiber in die Chip-Zuleitungen geschaltet ist, um Signale auf den Chip-Zuleitungen zu verstärken.

2. Zwischentreiber für diskrete Wafer-Scale-Integrationssysteme nach Anspruch 1, **dadurch gekennzeichnet,** daß ein Eingang eines Zwischentreibers mit einem chipimplementierten Pad (P2) und der Ausgang desselben mit einem zusätzlichen auf dem Chip zu implementierenden Pad (P3) verbunden ist.

3. Zwischentreiber für diskrete Wafer-Scale-Integrationssysteme nach Anspruch 1, **dadurch gekennzeichnet,** daß Ein- und Ausgänge eines Zwischentreibers über zusätzliche auf dem Chip zu implementierenden Pads verbunden sind.

4. Zwischentreiber für diskrete Wafer-Scale-Integrationssysteme nach einem der Ansprüche 1 bis 3, **dadurch gekennzeichnet**, daß bei in CMOS-Technologie aufgebauten Chips, die Zwischentreiber aus zwei hintereinander geschalteten Inverterstufen (I1, I2) gebildet werden.

5. Zwischentreiber für diskrete Wafer-Scale-Integrationssysteme nach Anspruch 4, **dadurch gekennzeichnet,** daß die zwei Inverterstufen (I1, I2) jeweils einen p- und einen n-Kanal-MOS-Feldeffekttransistor (P1, N1; P2, N2) enthalten, daß jeweils ein erster Anschluß des n-Kanal-MOS-Feldeffekttransistors (N1, N2) der ersten und der zweiten Inverterstufe (I1, I2) mit Masse (V_{SS}) und jeweils er erster Anschluß des p-Kanal-MOS-Feldeffekttransistors (P1, P2) der ersten und zweiten Inverterstufe (I1, I2) mit der Versorgungsspannung (V_{DD}) verschaltet ist, daß ein Gateanschluß des n- und p-Kanal-MOS-Feldenffekttransistors (P1, N1) der ersten Inverterstufe (I1) einen Eingang (E) des Zwischentreibers bilden, daß ein zweiter Anschluß des n- und p-Kanal-MOS-Feldeffekttransistors (P1, N1) der ersten Inverterstufe (I1) untereinander und mit einem Gateanschluß des p- und n-Kanal-MOS-Feldeffekttransistors (P2, N2) der zweiten Inverterstufe (I2) verbunden ist, daß ein zweiter Anschluß des p- und n-Kanal-MOS-Feldeffekttransistors (P2, N2) der zweiten Inverterstufe (I2) miteinander verschaltet ist und einen Ausgang (A) des Zwischentreibers bildet.

## Claims

1. Intermediate driver for discrete wafer-scale-integration systems, in which a multiplicity of chips (C1', C3', C4', C7') are mounted on a pre-wired wafer and the multiplicity of chips are connected at least partially to one another and at least partially to inputs and outputs (A') via bonded chip leads, characterized in that, at least on one chip of the multiplicity of chips, a large-scale integrated circuit is integrated monolithically together with the intermediate driver, and in that the intermediate driver is connected into the chip leads in order to amplify signals on the chip leads.

2. Intermediate driver for discrete wafer-scale-integration systems according to Claim 1, characterized in that one input of an intermediate driver is connected to a chip-implemented pad (P2) and the output of the same is connected to an additional pad (P3) which is to be implemented on the chip.

3. Intermediate driver for discrete wafer-scale-integration systems according to Claim 1, characterized in that inputs and outputs of an intermediate driver are connected via additional pads which are to be implemented on the chip.

4. Intermediate driver for discrete wafer-scale-integration systems according to one of Claims 1 to 3, characterized in that, in the case of chips which are constructed using CMOS technology, the intermediate drivers are constructed from two series-connected invertor stages (I1, I2).

5. Intermediate driver for discrete wafer-scale-integration systems according to Claim 4, characterized in that the two invertor stages (I1, I2) each contain a p-channel and n-channel MOS field-effect transistor (P1, N1; P2, N2), in that a first connection of the n-channel MOS field-effect transistor (N1, N2) of the first and of the second invertor stage (I1, I2) is in each case connected to earth (V_{SS}), and a first connection of the p-channel MOS field-effect transistor (P1, P2) of the first and of the second invertor stage (I1, I2) is in each case connected to the supply voltage (V_{DD}), in that a gate connection of the n-channel and p-channel MOS field-effect transistors (P1, N1) of the first invertor stage (I1) form an input (E) of the intermediate driver, in that a second connection of the n-channel and p-channel MOS field-effect transistors (P1, N1) of the first invertor stage (I1) are connected to one another and to a gate connection of the p-channel and n-channel MOS field-effect transistors (P2, N2) of the second inverter stage (I2), and in that a second connection of the p-channel and n-channel MOS field-effect transistors (P2, N2) of the second invertor stage (I2) are connected to one another and form an input (A) of the intermediate driver.

## Revendications

1. Circuit intermédiaire d'attaque pour des systèmes discrets à intégration à l'échelle d'une tranche, dans lequel un grand nombre de puces (C1', C3', C4', C7') est monté sur une tranche précâblée, les puces étant reliées au moins en partie entre elles et au moins en partie avec des entrées et des sorties (A'), par l'intermédiaire de conduteurs d'alimentation connectés pour les puces,
caractérisé en ce
- qu'au moins sur une puce du grand nombre de puces est intégré monolithiquement, conjointement avec le circuit intermédiaire d'attaque, un circuit de commutation à haute intégration,
- et que le circuit intermédiaire d'attaque est monté dans lesdits conducteurs d'alimentation pour les puces, afin d'amplifier des signaux appliqués à ceux-ci.

2. Circuit intermédiaire d'attaque pour des systèmes discrets à intégration à l'échelle d'une tranche, suivant la revendication 1, caractérisé en ce qu'une entrée d'un circuit intermédiaire d'attaque est reliée à une plage de connexion (P2) implantée sur la puce et la sortie de ce circuit intermédiaire d'attaque est reliée à une plage de connexion (P3) supplémentaire à implanter sur la puce.

3. Circuit intermédiaire d'attaque pour des systèmes discrets à intégration à l'échelle d'une tranche, suivant la revendication 1, caractérisé en ce que des entrées et des sorties d'un circuit intermédiaire d'attaque sont reliées, par l'intermédiaire de plages de connexion supplémentaires à implanter sur la puce.

4. Circuit intermédiaire d'attaque pour des systèmes discrets à intégration à l'échelle d'une tranche, suivant l'une des revendications 1 à 3, caractérisé en ce que, pour des puces formées en technologie CMOS, les circuits intermédiaires d'attaque sont formés à partir de deux étages inverseurs (I1, I2) branchés en série.

5. Circuit intermédiaire d'attaque pour des systèmes discrets à intégration à l'échelle d'une tranche, suivant la revendication 4, caractérisé en ce que les deux étages inverseurs (I1, I2) comportent respectivement un transistor à effet de champ MOS à canal p et un transistor à effet de champ MOS à canal n (P1, N1; P2, N2), qu'une première borne du transistor à effet de champ MOS à canal n (N1, N2) du premier et du deuxième étages inverseurs (I1, I2) est reliée à la masse (V_{SS}) et que respectivement une première borne des transistors à effet de champ MOS à canal p (P1, P2) du premier et du deuxième étages inverseurs (I1, I2) est reliée à la tension d'alimentation (V_{DD}), que respectivement une borne de grille des transistors à effet de champ MOS à canal p et à canal n (P1, N1) du premier étage inverseur (I1) forme une entrée (E) du circuit intermédiaire d'attaque, que chaque deuxième borne des transistors à effet de champ MOS à canal p et à canal n (P1, N1) du premier étage inverseur (I1) sont reliées entre elles et à chaque borne de grille des transistors à effet de champ MOS à canal p et à canal n (P2, N2) du deuxième étage inverseur (I2), que respectivement une deuxième borne des transistors à effet de champ MOS à canal p et à canal n (P2, N2) du deuxième étage inverseur (I2) forme une sortie (A) du circuit intermédiaire d'attaque.
